# EUROPÄISCHE PATENTSCHRIFT

(11) **EP 4 004 569 B1**
(45) Veröffentlichungstag und Bekanntmachung des Hinweises auf die Patenterteilung: **02.08.2023**
(21) Anmeldenummer: 20734345.0
(22) Anmeldetag: 19.06.2020
(51) Int. Cl.: G01R 31/16, G01R 31/12

(54) **VERFAHREN SOWIE VORRICHTUNG ZUR PRÜFUNG DER ISOLATION EINES ELEKTRISCHEN BAUTEILS, INSBESONDERE EINES HV-KABELSATZES**
METHOD AND DEVICE FOR TESTING THE INSULATION OF AN ELECTRIC COMPONENT, IN PARTICULAR OF AN HV CABLE HARNESS
PROCÉDÉ AINSI QUE DISPOSITIF POUR VÉRIFIER L'ISOLATION D'UN COMPOSANT ÉLECTRIQUE, EN PARTICULIER D'UN FAISCEAU DE CÂBLES HAUTE TENSION

(30) Priorität: 23.07.2019 DE 102019210866
(43) Veröffentlichungstag der Anmeldung: 01.06.2022
(73) Patentinhaber: LEONI Bordnetz-Systeme GmbH, 97318 Kitzingen (DE)
(72) Erfinder: VORNBERGER, Eginhard, 97320 Buchbrunn (DE)
(74) Vertreter: FDST Patentanwälte
(86) Internationale Anmeldenummer: PCT/EP2020/067066
(87) Internationale Veröffentlichungsnummer: WO 2021/013446

(56) Entgegenhaltungen:
- JP-A- S63 273 073
- KR-A- 20010 056 483
- US-A1- 2001 052 778
- US-B1- 6 518 772

## Beschreibung

Die Erfindung betrifft ein Verfahren sowie eine Vorrichtung zur Prüfung der Isolation eines elektrischen Bauteils, insbesondere eines Kabels, speziell eines Kabelsatzes und insbesondere eines Hochvolt-Kabels (HV-Kabel) bzw. eines Hochvolt - Kabelsatzes (HV-Kabelsatz).

Kabelsätze bestehen allgemein aus mehreren miteinander verbundenen Komponenten. So werden bei Kabelsätzen typischerweise mehrere Einzelleitungen oder Einzelkabel zusammengefasst und bilden typischerweise eine verzweigte Struktur aus. Die einzelnen Leitungen oder Kabel sind dabei vorkonfektioniert, weisen endseitig also bereits Kontaktelemente oder auch Stecker auf. Einzelne Kabel können innerhalb des Kabelsatzes auch miteinander verbunden sein, beispielsweise über Verteiler oder Verbinder etc.

Bei der Herstellung eines Kabelsatzes werden mehrere Konfektionierungsschritte durchlaufen. Am Ende einer Kabelsatzfertigung erfolgt generell eine Funktionsprüfung. Unter anderem wird bei dieser auch die Integrität der Isolation des Kabelsatzes überprüft. Bei dieser auch als "Isolationstest" beschriebener Prüfung wird beispielsweise sichergestellt, dass keine spannungsführenden Leiterteile durch einen Isolationsmantel durchgedrungen sind und/oder dass die Integrität der Isolation sichergestellt ist. Bei geschirmten HV-Kabeln kann dazu ein Isolationswiderstand der Isolierung gegen den um den inneren Leiter angebrachten Schirm gemessen werden.

Bei ungeschirmten HV-Kabeln oder HV-Kabelsätzen besteht diese Möglichkeit nicht. Als ein Standardverfahren wird der Kabelsatz in ein Salzwasserbad getaucht, sodass der Kabelsatz komplett vom Bad umschlossen ist. Bei dieser Variante wird der Isolationswiderstand zwischen dem eigentlichen Hochvolt-Leiter und einem Salzbad-Behälter gemessen. Allerdings ist diese Messung aufwendig und zudem hinterlässt sie Salzwasserrückstände am Kabelsatz.

Zur Detektion von Schäden an der Isolierung von elektrischen Leitungen ist aus der DE 100 24 809 B4 eine Prüfzange zu entnehmen, mittels der die zu überprüfende Leitung zangenartig umfasst werden kann. In dem von der Zange umgriffenen Teilbereich der Leitung wird dabei ein abgeschlossener Prüfraum geschaffen, in den ein Prüfgas mit geringer Durchschlagspannung eingeleitet wird. Nach Anlegen einer Prüfspannung wird der Prüfraum im Hinblick auf Entladungen überprüft.

Aus der DE 33 09 658 A1 ist eine Vorrichtung zur optischen Prüfung der Durchschlagsfestigkeit einer elektrischen Isolation zu entnehmen, bei der eine Platte mit seitlichem Dichtungselement auf die zu prüfende Isolation aufgesetzt wird und zwischen der Platte und der zu prüfenden Isolation ebenfalls ein Prüfraum eingeschlossen ist, welcher beispielsweise evakuiert oder mit einem Testgas befüllt wird.

Aus der DE 28 016 49 A1 ist eine Prüfvorrichtung zu entnehmen, bei der ein zu prüfendes Kabel in eine das Kabel umgebende Röhre eingelegt wird und ebenfalls mit einem Prüfgas gefüllt wird.

Aus der DE 10 2016 116 695 A1 ist ein Verfahren zum Überprüfen eines Kabelbaums zu entnehmen, bei dem an einem Kabel in einem Prüfabschnitt eine Manschette angelegt wird, um zu überprüfen, ob eine spezielle Prüfleitung des Kabelsatzes in dem Prüfabschnitt liegt.

Aus der US 6 518 772 B1 ist eine Prüfzange zur Überprüfung eines Kabelsatzes zu entnehmen. Die Prüfzange weist zwei aneinander gelagerte Arme auf und umgreift den zu prüfenden Kabelsatz. Über stirnseitige Dichtungen ist ein Prüfraum gebildet, in dem ein Prüfmedium eingebracht wird. Die Prüfzange wird zum Testen des Kabels sukzessive am Kabel entlang geführt.

Aus der KR 2001 0056483 A ist eine Prüfvorrichtung zur Überprüfung einer Hochdruckelektrode zu entnehmen.

Aus der JP S63 273073 A ist eine weitere Prüfvorrichtung zur Prüfung einer Isolation eines Kabels zu entnehmen. Das Kabel wird in einen Container eingelegt, welcher mit Argon gefüllt wird.

Aus US 2001 / 052 778 A1 ist eine Prüfvorrichtung zu entnehmen, die einen seitlich offenen, aufblasbaren Schlauch aufweist, durch den das zu prüfende Kabel hindurchgeführt wird. Dabei ist vorgesehen, dass der Schlauch entlang des Kabels verfahren wird, um unterschiedliche Regionen des Kabels zu überprüfen

Die aus dem Stand der Technik bekannten Messverfahren und Prüfverfahren sind häufig vergleichsweise aufwendig. Darüber hinaus ist bei vielen Prüfverfahren als nachteilig anzusehen, dass sie lediglich einzelne Abschnitte von Kabeln prüfen.

Ausgehend hiervon liegt der Erfindung die Aufgabe zugrunde, ein Verfahren sowie eine Vorrichtung zur Prüfung der Isolation eines elektrischen Bauteils, insbesondere eines HV-Kabelsatzes anzugeben.

Die auf das Verfahren gerichtete Aufgabe wird gelöst durch ein Verfahren zur Prüfung der Isolation eines elektrischen Bauteils mit den Merkmalen des Anspruchs 1. Bei dem elektrischen Bauteil handelt es sich insbesondere um ein Kabel, speziell um einen Kabelsatz, insbesondere um ein Hochvolt-Kabel (HV-Kabel), speziell um ein Hochvolt -Kabelsatz (HV-Kabelsatz).

Grundsätzlich eignet sich das nachfolgend beschriebene Verfahren sowie die Vorrichtung auch zur Prüfung von anderen elektrischen Bauteilen, beispielsweise ein elektrisches Gerät, bei dem elektrische Komponenten von einem Isolationsgehäuse umgeben sind. Das elektrische Bauteil weist allgemein einen elektrischen Kern auf, welcher von der zu prüfenden Isolation umgeben ist. Die Isolation ist beispielsweise ein Kabelmantel und / oder ein Isolationsgehäuse. Beim bestimmungsgemäßen Gebrauch des elektrischen Bauteils ist an den elektrischen Kern eine Spannung angelegt. Bei einem Kabel handelt es sich bei dem elektrischen Kern insbesondere um einen Leiter, der von einem Kabelmantel als Isolierung umgeben ist. Bei mehrteiligen Kabeln, speziell mehradrigen Kabeln, ist der elektrische Kern gebildet durch die mehreren Leiter, die jeweils von einer Leiterisolation (Adermantel) umgeben sind und jeweils eine Ader bilden. Das mehradrige Kabel ist von einem gemeinsamen Kabelmantel umgeben, der zumindest ein Teil der zu prüfenden Isolation ist.

Zur Prüfung, ob die Isolation einen Fehler aufweist, wird eine Prüfhülle bereitgestellt, in der das zu prüfende Bauteil bei der Prüfung einliegt. Die Prüfhülle weist dabei eine Wandung aus einem flexiblen und elektrisch leitfähigen Material auf, wobei die Flexibilität der Prüfhülle derart beschaffen ist, dass sie sich an die Isolation flächig anlegt, so dass sie eine Außenkontur der Isolation aufnimmt und diese nachbildet.

Bei der Prüfung wird an den elektrischen Kern eine Prüfspannung angelegt und durch eine geeigente Messung ermittelt, ob die Isolierung den Qualitätsanforderungen entspricht oder ob die Isolation schadhaft ist. Die Prüfhülle wird daher nach Art einer Elektrode eingesetzt. Insbesondere wird geprüft, ob über die Messhülle ein Leckstrom abfließt und insbesondere auch, wie hoch dieser Leckstrom ist, um zu entscheiden, ob dieser einen kritischen Wert überschreitet. Alternativ wird das an der Messhülle anliegende Potential, beispielsweise gegenüber einem Bezugspotenzial gemessen. Allgemein wird daher eine elektrische Eigenschaft der Prüfhülle gemessen und anhand des Messergebnisses ermittelt, ob die Isolierung den Qualitätsanforderungen entspricht oder schadhaft ist.

Der besondere Vorteil bei diesem Verfahren ist in der Prüfhülle mit der flexiblen, elektrisch leitfähigen Wandung zu sehen. Durch diese Maßnahme besteht die Möglichkeit, das zu überprüfende Bauteil, speziell einen HV-Kabelsatz vollständig oder zumindest nahezu vollständig in die Prüfhülle einzulegen und dann die gesamte Isolation des Bauteils mit nur einer Messung zu überprüfen. Wesentlich ist hierbei, dass aufgrund der Flexibilität der Prüfhülle diese der Außenkontur der Isolierung folgt, sodass auch lokale Schadstellen zuverlässig erfasst werden.

Ein weiterer Vorteil der Messmethode mit dieser flexiblen Prüfhülle ist darin zu sehen, dass keine zusätzlichen Medien, wie beispielsweise Salzwasser oder spezielle Prüfgase eingebracht werden, die dann in einem Zwischenraum zwischen der als Elektrode dienenden Prüfhülle und der Isolation angeordnet sind. Es wird daher auf derartige zusätzliche Prüfmedien, wie Prüfgas oder Prüfflüssigkeit verzichtet. Die Prüfhülle liegt unmittelbar und flächig an der Isolation an.

Bei der Prüfhülle handelt es sich dabei um eine Prüftasche, die das zu prüfende Bauteil in sich aufnimmt. Unter einer "Prüftasche" wird dabei allgemein verstanden, dass diese zwei gegenüberliegende Hüllflächen aufweist, die - zumindest bei der Durchführung des Prüfverfahrens oder alternativ dauerhaft - an zumindest drei Randseiten miteinander verbunden sind. Bevorzugt sind die Randseiten über ein Verschlusselement insbesondere reversibel verschließbar. Die Prüftasche definiert daher einen geschlossenen Prüfraum, welcher lediglich zu einer Randseite hin eine Öffnung aufweist. Während des Prüfvorgangs ist diese vorzugsweise ebenfalls verschließbar. In der Prüftasche liegt bei der Prüfung das Bauteil ein, vorzugsweise vollständig ein. Die Prüftasche bildet daher einen geschlossenen Prüfraum, welcher nur zu einer Seite hin die insbesondere verschließbare Öffnung aufweist. An dieser Öffnung ist bei der Prüfung zumindest ein Ende des Bauteils, vorzugsweise mehrere Enden des Bauteils zum Anschluss an eine Spannungsversorgung, speziell zum Anschluss an die Prüfspannung herausgeführt. Die herausgeführten Enden sind speziell durch Kontaktanschlüsse gebildet. Alternativ liegt das Bauteil vollständig in der Prüfhülle ein und der Spannungsanschluss erfolgt über die Öffnung mittels eines Anschlusselements.

Allgemein nimmt die Prüfhülle das Bauteil zumindest weitgehend vollständig auf. Unter "weitgehend vollständig" wird hierbei verstanden, dass das zu prüfende Bauteil bis auf eventuelle Anschlussbereiche des zu prüfenden Bauteils vollständig in der Prüfhülle einliegt. Die Anschlussbereiche des Bauteils, die aus der Prüfhülle herausgeführt werden, dienen zum Anlegen der Prüfspannung. Im Falle eines HV-Kabelsatzes werden daher allenfalls die beispielsweise mit einem Stecker vorkonfektionierten Enden herausgeführt, der Rest des Kabelsatzes, also beispielsweise zumindest 90% (der gesamten Kabellänge) werden in der Prüfhülle aufgenommen. Bevorzugt liegt das komplette zu prüfende Bauteil, insbesondere der HV-Kabelsatz in der Prüfhülle, speziell in der Prüftasche ein.

Das nachfolgend beschriebene Prüfverfahren mit der speziellen Prüfhülle kann gleichermaßen auch für Prüfsituationen herangezogen werden, bei denen das Bauteil alternativ nur teilweise, beispielsweise in Abschnitten in der Prüfhülle einliegt, die wiederum als Prüftasche ausgebildet sein kann.

Unter Kabelsatz wird vorliegend verstanden, dass mehrere einzelne Kabel oder Leitungen zu einer Einheit miteinander verbunden sind und typischerweise eine verzweigte Struktur ausbilden. Häufig sind die einzelnen Kabel dabei beispielsweise über Verteiler oder Verbinder miteinander verbunden oder zumindest endseitig mit Kontaktelementen und/oder Steckerelementen vorkonfektioniert.

Unter Hochvolt-Kabel oder - Kabelsatz wird verstanden, dass das jeweilige Kabel bzw. der jeweilige Kabelsatz dabei jeweils für hohe Spannungen von insbesondere mehr als 250 Volt, vorzugsweise mehr als 500 Volt oder auch mehr als 1.000 Volt und vorzugsweise bis maximal 1.500 bis 2.000 Volt ausgelegt ist. Die HV-Kabel sind typischerweise zur Leitung von hohen Strömen ausgelegt und weisen entsprechend einen großen Leiterquerschnitt von beispielsweise mehreren Quadratmillimetern (mm²) beispielsweise mehr als 2,5 mm² auf. Derartige HV-Kabelsätze werden beispielsweise in der Automobilindustrie eingesetzt, speziell für Kraftfahrzeuge mit elektrischem Fahrmotor (Elektro-Fahrzeug oder HybridFahrzeug).

Bei dem einzelnen HV-Kabel handelt es sich typischerweise um eine einadrige Leitung, die entweder nach Art einer Koaxialleitung mit einem Schirm als Außenleiter versehen ist oder bei der kein Schirm angeordnet ist. In letzterem Fall besteht das HV-Kabel beispielsweise lediglich aus dem Leiter und der diesen umgebende Isolierung, die also einen Ader- oder Kabelmantel bildet. Grundsätzlich kann das einzelne HV-Kabel auch ein mehradriges Kabel sein, bei dem die einzelnen Kabeladern von einem gemeinsamen Isolationsmantel als Isolierung umgeben sind.

Gemäß einer bevorzugten Ausgestaltung wird in der Prüfhülle bei einliegendem Bauteil ein Unterdruck gegenüber einem außerhalb der Prüfhülle herrschenden Druck erzeugt. Hierdurch schmiegt sich die Prüfhülle, also ihre Wandung, an die Isolation an und berührt die Isolation großflächig, insbesondere vollflächig. Unter "großflächig" wird verstanden, dass die Isolation zu mehr als 60%, vorzugsweise zu mehr als 80% und insbesondere zu mehr als 90% von der Prüfhülle berührt wird. D.h. lediglich ein kleiner Anteil der Oberfläche der zu prüfenden Isolation wird nicht von der Prüfhülle berührt.

Unter "Unterdruck" wird hierbei ein Unterdruck von zumindest 150 hPa (150mbar), vorzugsweise von zumindest 250 hPa verstanden. Vorzugsweise beträgt der Unterdruck maximal 1000 hPa (1 bar) und speziell maximal 500 hPa. Bevorzugt wird ein Unterdruck im Bereich von 200 hPa und 500 hPa eingestellt.

Die Prüfhülle weist hierzu vorzugsweise einen Sauganschluss auf, an den zum Erzeugen des Unterdrucks eine Saugleitung angeschlossen wird. Bei dem Sauganschluss handelt es sich beispielsweise um ein hülsen- oder buchsenförmiges Element, welches insbesondere dichtend in die Wandung eingebracht ist und einen Strömungsweg in den Innenraum der Prüfhülle ermöglicht. Die Buchse besteht dabei typischerweise aus einem im Vergleich zur Wandung deutlich steiferen Material, speziell Kunststoff. Bevorzugt weist der Sauganschluss ein insbesondere automatisch wirkendes Verschlussventil, wie einen Membranverschluss auf, welcher ein Einströmen von Luft nach Erzeugen des Unterdrucks verhindert.

In bevorzugter Ausgestaltung ist die Prüfhülle weiterhin bei einliegendem Bauteil luftdicht verschließbar. Je nach Flexibilität und Oberflächenbeschaffenheit der Prüfhülle kann auf ein Verschlusselement verzichtet werden, da beim Anlegen eines Unterdrucks gegenüberliegende Wandungsbereiche der Prüfhülle aufeinandergezogen werden und dann evtl. sogar selbstdichtend sind.

Bevorzugt sind jedoch für das insbesondere luftdichte Verschließen ein oder mehrere separate Verschlusselemente vorgesehen. Beispielsweise lassen sich Randbereiche der Prüfhülle über einen Zipp-Verschluss oder über Haft- oder Klebestreifen verschließen. Dieses zumindest eine Verschlusselement ist dabei insbesondere integraler Bestandteil der Wandung, also mit dieser fest verbunden.

Weiterhin sind erforderliche Durchführungen, beispielsweise für die Durchführung der Endbereiche des zu prüfenden Kabelsatzes, zweckdienlicherweise als luftdichte Durchführungen ausgebildet. Hierzu sind beispielsweise in die Prüfhülle integrierte, bevorzugt halbschalenartige Verstärkungen oder Abdichtelemente eingearbeitet, die dann um den durchgeführten Kabelabschnitt gelegt werden und diesen jeweils dichtend umschließen. Ergänzend können noch von außen randseitig angebrachte Fixierklammern etc. vorgesehen sein, die die Prüfhülle gegen den durchgeführten Teilbereich des Kabels drücken.

Weiterhin weist die Prüfhülle vorzugsweise einen Messanschluss zum Anschluss eines Messgeräts auf, mittels dessen die elektrische Eigenschaft gemessen wird, insbesondere die Prüfhülle auf eine anliegende Spannung überprüft wird. Der Messanschluss ist beispielsweise ein Kontaktbolzen, eine Kontaktbuchse oder ein sonstiges Steckelement.

Das Bauteil weist allgemein zumindest einen Kontaktanschluss auf, an dem beim bestimmungsgemäßen Gebrauch eine Spannung anliegt. Bei einem Kabel oder einem Kabelsatz handelt es sich hierbei um ein endseitig angeschlagenes Kontaktelement, insbesondere um einen Kabel(satz)stecker. Üblicherweise weist der Kabelsatz mehrere solcher Kabelsatzstecker auf.

In bevorzugter Ausgestaltung liegt während der Prüfung zumindest ein oder mehrere derartiger Kontaktanschlüsse, insbesondere Kabeslsatzstecker, in der Prüfhülle ein. Zumindest ein Anschlussende des zu prüfenden Bauteils liegt daher in der Prüfhülle ein. Hierdurch wird bei der Prüfung zugleich auch die Isolationsfestigkeit des angeschlossenen Kontaktelements überprüft.

Um eine vollständige Prüfung des gesamten Bauteils, speziell Kabelsatzes, zu ermöglichen, liegt der Kabelsatz vollständig innerhalb der Prüfhülle ein. Vorzugsweise ist hierzu ein Anschlusselement ausgebildet, welches in die Prüfhülle integriert ist, und an das das im Inneren der Prüfhülle liegende Bauteil, speziell der Kabelsatz, über den Kontaktanschluss anschließbar ist. Bei dem Anschlusselement handelt es sich insbesondere um ein Steckerelement, welches also einen Gegenstecker zum Kabelsatzstecker bildet. Hierdurch entfällt die Notwendigkeit, ein Teilstück des zu prüfenden Bauteils aus der Prüfhülle herauszuführen. Das Bauteil, speziell der Kabelsatz, ist daher im Inneren der Prüfhülle speziell über eine Steckverbindung an das integrierte Anschlusselement angeschlossen.

Das Anschlusselement selbst ist wiederum bevorzugt abgedichtet durch die Wandung der Prüfhülle geführt und weist außenseitig einen Anschlusskontakt, beispielsweise einen Steckkontakt zum Anlegen der Prüfspannung auf.

Über die Kontaktanschlüsse des Bauteils wird allgemein bei der Prüfung die Prüfspannung entweder direkt oder mittelbar über das integrierte Anschlusselement angelegt.

Bei der Wandung handelt es sich allgemein um eine hochflexible, speziell folienartige oder auch stoffartige Umhüllung. Diese weist eine geringe Steifigkeit auf, sodass sie sich ohne Weiteres an die Außenkontur des zu prüfenden Bauteils speziell bei der Anlegung des Unterdrucks anschmiegen kann. Insbesondere weist die Wandung eine Wandungsstärke oder Dicke im Bereich bis maximal 300 µm, vorzugsweise bis maximal 200 µm oder bis maximal 100 µm auf.

Speziell weist die Wandung einen folienartigen Charakter auf, wie es beispielsweise allgemein bei der Verpackung von Lebensmitteln, speziell bei der vakuumdichten Verpackung von Lebensmitteln, beispielsweise mittels sogenannter Gefrierbeutel, bekannt ist.

Insgesamt ist die Wandung der Prüfhülle vorzugsweise durch eine leitfähige Kunststofffolie oder durch eine mit einer leitfähigen Beschichtung versehene Kunststofffolie gebildet.

In einer bevorzugten Alternative weist die Wandung eine insbesondere nicht leitfähige Folie sowie eine weitere, leitfähige Lage auf. Die leitfähige Lage ist insbesondere als ein Gewebe oder ein Geflecht aus leitfähigen Fasern/Fäden, beispielsweise Feinstdrähten, gebildet. Die leitfähige Lage ist nach innen in Richtung zum Innenraum der Prüfhülle orientiert und durch eine gasdichte äußere Lage bildende Folie nach außen gebildet.

Insbesondere bei dieser Ausführungsvariante mit der innenliegenden leitfähigen Lage ist der Messanschluss beispielsweise durch ein durch die Folie hindurchgeführtes Kontaktelement verwirklicht, welches mit der Wandung befestigt ist. Speziell handelt es sich hierbei um ein mechanisch befestigtes Element, beispielsweise eine Kontaktschraube. Das Kontaktelement ist bevorzugt luftdicht durch die äußere durch die Folie gebildete Lage hindurchgeführt. Grundsätzlich kann dieses Prinzip der Kontaktierung mit einem durch die Wandung hindurchgeführten Kontaktelement auch bei der Verwendung einer leitfähigen oder mit einer leitfähigen Beschichtung versehenen Folie eingesetzt werden.

In einer bevorzugten Ausführungsvariante ist die Prüfhülle, speziell deren Wandung im Ausgangszustand als eine beispielsweise einlagige Folienlage ausgebildet, wobei das zu prüfende Bauteil zunächst auf einen ersten Teil, nämlich ein Unterteil der Prüfhülle, aufgelegt wird und anschließend ein weiteres Teil, nachfolgend als Oberteil bezeichnet, über das zu prüfende Bauteil gelegt wird. Das heißt, die Folienlage wird quasi einmal gefaltet und überdeckt dann mit Ober- und Unterteil das zu prüfende Bauteil vollflächig. Anschließend erfolgt vorzugsweise das bereits zuvor beschriebene luftdichte Verschließen der verbleibenden offenen Seitenteile. Das oder die Verschlusselemente verlaufen insbesondere entlang der offenen Randseiten beispielsweise U-förmig.

In bevorzugter Ausgestaltung verbleibt das zu prüfende Bauteil nach der Prüfung in der Prüfhülle und diese wird als eine Schutzhülle oder auch als eine Transportverpackung beispielsweise nach Art eines Einwegartikels verwendet. Hierdurch erfüllt also die Prüfhülle eine Doppelfunktion, nämlich einerseits zum Prüfen des Kabelsatzes als auch als Transportverpackung bis zu einem vorgesehenen Einsatzort. Neben der Ausgestaltung als Einwegartikel wird die Prüfhülle alternativ nach Art eines Kreislaufsystems wiederkehrend für die Prüfung auch von weiteren Bauteilen eingesetzt.

Die Aufgabe wird erfindungsgemäß weiterhin gelöst durch eine Vorrichtung zum Prüfen der Isolation eines elektrischen Bauteils mit den Merkmalen des Anspruchs 14

Die zuvor im Hinblick auf das Verfahren angeführten Vorteile und bevorzugten Ausgestaltungen sind sinngemäß auch auf die Vorrichtung zu übertragen.

Die Vorrichtung weist die Prüfhülle und vorzugsweise weiterhin ein Messgerät und vorzugsweise auch eine Vakuumpumpe auf.

Ausführungsvarianten der Erfindung werden nachfolgend anhand der Figuren näher erläutert. Diese zeigen jeweils in stark vereinfachten Darstellungen:
- Fig. 1A: eine Prüfhülle in aufgeklapptem Zustand mit einem aufgelegten HV-Kabelsatz,
- Fig. 1B: die Prüfhülle gemäß Fig. 1A im geschlossenen Zustand mit darin einliegendem HV-Kabelsatz,
- Fig. 2: eine zweite Ausführungsvariante einer Prüfhülle mit einem darin einliegenden HV-Kabelsatz,
- Fig. 3: eine Stirnansicht auf eine geschlossene Prüfhülle im Bereich einer stirnseitigen Durchführung sowie
- Fig. 4: eine ausschnittsweise Schnittdarstellung einer Ausführungsvariante der Prüfhülle mit integriertem Messanschluss.

In den Figuren sind gleich wirkende Teile mit den gleichen Bezugszeichen dargestellt.

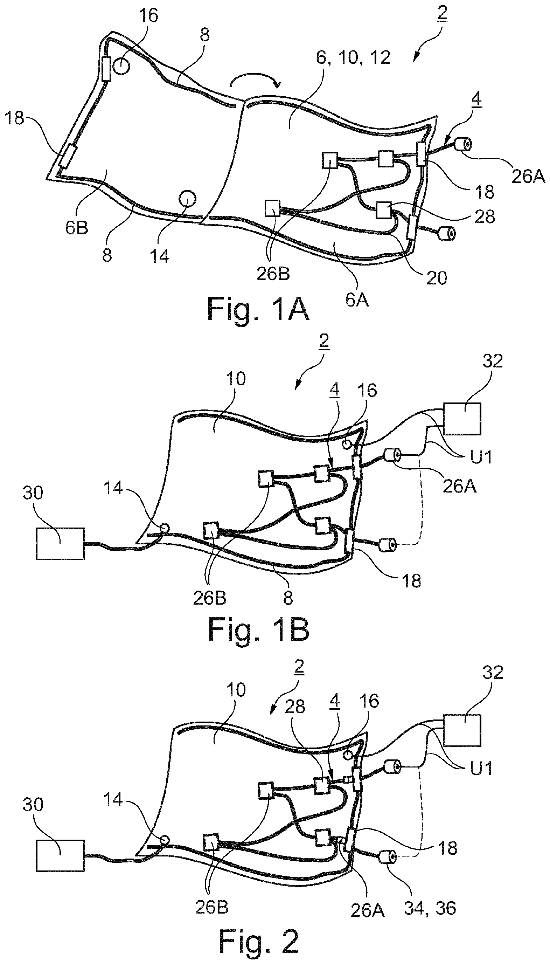

Fig. 1A zeigt eine Prüfhülle 2, die im dargestellten Ausführungsbeispiel eine aufgeklappte Folienlage 6 aufweist mit einem ersten Teil, nachfolgend als Unterteil 6A bezeichnet sowie einem weiteren Teil, nachfolgend als Oberteil 6B bezeichnet. Auf dem Unterteil 6A liegt das Bauteil in Form eines Kabelsatzes 4 auf. Nach dem Auflegen des Kabelsatzes 4 werden die beiden Teile 6A,6B wie durch den Pfeil in Fig. 1A angedeutet, aufeinander geklappt, sodass das Oberteil 6B auf dem Unterteil 6A unter Zwischenlage des Kabelsatzes 4 aufliegt. Die beiden Teile 6A,6B bilden dadurch insgesamt eine Prüftasche aus, in der der Kabelsatz 4 einliegt. Alternativ hierzu ist die Prüfhülle 2 bereits im Ausganszustand als eine Prüftasche ausgebildet, die nur zu einer Seite offen ist, über die das zu prüfende Bauteil eingelegt wird.

Zum insbesondere luftdichten Verschließen weist die Prüfhülle 2 ein oder mehrere Verschlusselemente 8 auf. Diese verlaufen vorzugsweise randseitig und sind beispielsweise nach Art einer Verschlussleiste ausgebildet, wie beispielsweise ein Zipp-Verschluss oder ein Druckverschluss. Beim Druckverschluss werden - wie z.B. aus dem Bereich der Gefrierbeutel bekannt - zwei Profilleisten miteinander zum Verschließen ineinander gepresst. Alternativ ist das Verschlusselement als ein Haft- oder Klebestreifen ausgebildet. Dieser verläuft beispielsweise randseitig sowohl entlang des Oberteils 6B als auch entlang des Unterteils 6A, wie dies in der Fig. 1A dargestellt ist.

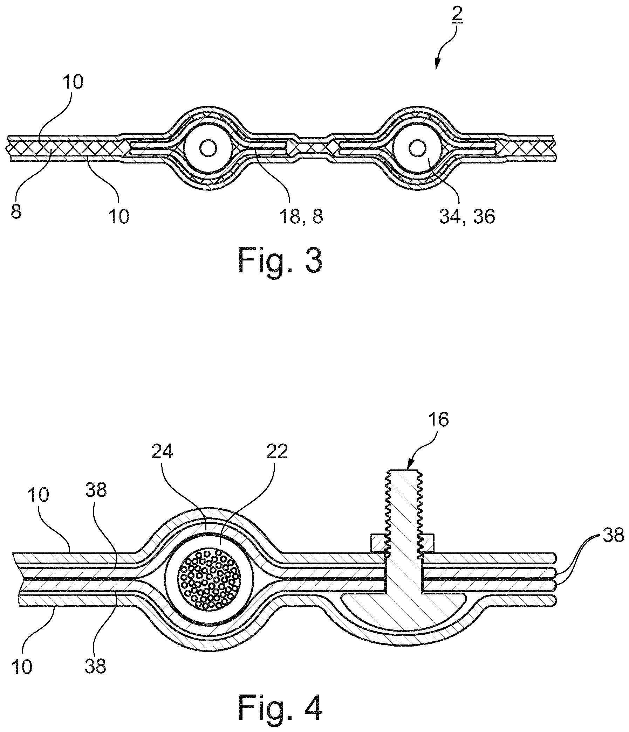

Die Folienlage 6 ist dabei beispielsweise durch eine Kunststofffolie 10 gebildet, die entweder eine intrinsische Leitfähigkeit aufweist oder mit einer leitfähigen Beschichtung versehen ist. Schließlich besteht auch die Möglichkeit, dass zusätzlich eine leitfähige Lage angeordnet ist, wie dies in Fig. 4 dargestellt ist. Die Prüfhülle 2 weist weiterhin allgemein eine Wandung 12 auf, die im Ausführungsbeispiel der Fig.1B durch die Kunststofffolie 10 gebildet ist. Durch die Wandung 12 ist die Prüfhülle 2 zur Umgebung hin insbesondere luftdicht abgeschlossen. Die Wandung schließt insofern - bei einligendem Kabelsatz 4, wenn die Prüfhülle 2 eine Prüftasche bildet - einen Innenraum der Prüfhülle zur Umgebung hin ab. Die Wandung 12 ist gasdicht ausgebildet.

Ergänzend weist die Prüfhülle 2 einen Sauganschluss 14 sowie einen Messanschluss 16 auf.

Der Sauganschluss 14 sowie der Messanschluss 16 sind jeweils integrierte Bestandteile der Prüfhülle 2 und insbesondere mit der Wandung 12 fest verbunden.

Die Prüfhülle 2 weist weiterhin Durchführungselemente 18 auf, die insbesondere zum abgedichteten, luftdichten Durchführen zumindest eines Elementes durch eine verbleibende (Befüll-) Öffnung der zur Prüftasche ausgebildeten Prüfhülle 2 dienen. Bei dem Element handelt es sich im Ausführungsbeispiel der Fig. 1A, 1B um ein Kabel 20 des Kabelsatzes 4. Diese Durchführungselemente 18 dienen daher ebenfalls als Verschlusselemente 8. Sie sind beispielsweise jeweils nach Art von Halbschalen aus einem Dichtmaterial, beispielsweise Kunststoff oder Gummi, ausgebildet und sind jeweils vorzugsweise fest mit der Kunststofffolie 10 verbunden. Ein jeweiliges Paar an Halbschalen bildet dabei jeweils ein Durchführungselement 18. Die Halbschalen lassen sich beispielsweise miteinander durch lösbare Verbindungen, beispielsweise eine Clip-Verbindung oder auch eine Klett-Verbindung etc., miteinander verbinden.

Die aus der Prüfhülle 2 herausgeführten Endstücke des Kabelsatzes 4 werden daher einfach auf die jeweiligen Halbschalen aufgelegt und anschließend beim Verschließen der Prüfhülle 2 werden die jeweiligen Oberteile der Halbschalen mit den Unterteilen verbunden, sodass die jeweiligen Kabel 20 luftdicht herausgeführt sind.

Der Kabelsatz 4 weist allgemein mehrere Kabel 20 auf, die jeweils als HV-Kabel ausgebildet sind. Im Ausführungsbeispiel ist ein jeweiliges Kabel 20 als ein einadriges Kabel ausgebildet, welches lediglich einen zentralen Leiter 22 als einen elektrischen Kern aufweist, welcher von einer Isolation 24 direkt umgeben ist, die also einen Adermantel ausbildet (vgl. hierzu Fig. 4). Der Kabelsatz 4 weist an einer Anschlussseite im Ausführungsbeispiel zwei vorkonfektionierte elektrische, erste Kontaktanschlüsse 26A auf, die bevorzugt nach Art von Steckern ausgebildet sind und insofern Kabelsatzstecker bilden. Die ersten Kontaktanschlüsse 26A sind in der in Fig. 1A, 1B dargestellten Situation außerhalb der Prüfhülle 2 angeordnet. Daneben weist der Kabelsatz 4 weitere elektrische, zweite Kontaktanschlüsse 26B auf, die innerhalb der Prüfungshülle 2 angeordnet sind.

Der Kabelsatz 4 weist insgesamt eine verzweigte Struktur auf mit mehreren Kabeln 20, die im Ausführungsbeispiel über Verteiler 28. miteinander verbunden sind. Bei den Verteilern 28 handelt es sich um 1-2-Verteiler, d.h. ein eingehendes Kabel 20 wird auf zwei ausgehende Kabel 20 aufgeteilt. An den inneren, zweiten Kontaktanschlüssen 26B sind jeweils zwei Kabel 4 angeschlossen. In diesen zweiten Kontaktanschlüssen 26B liegen dabei jeweils (Steck-)Kontaktelemente ein, es handelt sich also bei diesen insbesondere um zweipolige Kontaktanschlüsse 26B. Bei den äußeren, ersten Kontaktanschlüssen 26A handelt es sich demgegenüber vorzugsweise um einpolige Kontaktanschlüsse 26A, die im Betrieb mit einem Pluspol bzw. Minuspol einer Versorgungsspannung, z.B. einer Batterie verbunden sind.

Zur Prüfung der Isolation 24 des Kabelsatzes 4 sind vorzugsweise die beiden Kontaktelemente der innenseitig angeordneten zweiten Kontaktanschlüsse 26 B elektrisch miteinander verbunden.

Im Ausführungsbeispiel der Fig. 1A sind die ersten Kontaktanschlüsse 26A des Kabelsatzes 4 nach außen durch die Durchführungen 18 herausgeführt. Der restliche Kabelsatz 4, insbesondere auch die zweiten Kontaktanschlüsse 26B, liegen in der Prüfhülle 2 für die nachfolgende Prüfung luftdicht abgeschlossen ein. Insgesamt liegt damit der Kabelsatz 4 nahezu vollständig in der Prüfhülle 2 ein. Hierunter wird verstanden, dass mindestens 90% der aufsummierten Länge der einzelnen Kabelstränge des Kabelsatzes 4 in der Prüfhülle 2 aufgenommen wird. Speziell wird zumindest ein Teil der jeweils endseitig an den einzelnen Kabeln 20 angeschlagenen Kontaktanschlüsse 26B von der Prüfhülle 2 mit aufgenommen.

Im nachfolgend noch genauer beschriebenen Ausführungsbeispiel der Fig. 2 ist der Kabelsatz 4 vollständig von der Prüfhülle 2 aufgenommen, d.h. sämtliche Kontaktanschlüsse 26A, 26B liegen im Inneren der Prüfhülle 2 ein.

Der Kabelsatz 4 definiert daher insgesamt ein zu überprüfendes elektrisches Bauteil, welches einen elektrischen Kern aufweist, der durch die einzelnen Leiter 22 der einzelnen Kabel 20 sowie aber auch durch die in den Kontaktanschlüssen 26B,26A einliegenden Kontaktelemente gebildet ist. Die Isolation 24 dieses Kabelsatzes 4 wird gebildet zum einen durch die Adermäntel der einzelnen Kabel 20 sowie aber auch durch die einzelnen Isoliergehäuse der weiteren Bauteile, wie z.B. die Isoliergehäuse der Verteiler und der Kontaktanschlüsse 26B.

Zur Überprüfung, ob die Isolation 24 fehlerhaft ist, wird bei dem Verfahren zur Prüfung der Isolation 24 wie folgt vorgegangen:
Zunächst wird der Kabelsatz 4 in die als Prüftasche ausgebildete Prüfhülle 2 eingelegt, d.h. der Kabelsatz 4 ist zumindest nahezu vollständig oder vollständig im Inneren der Prüfhülle 2 aufgenommen. Diese ist vorzugsweise luftdicht verschlossen. Über den Sauganschluss 14 wird anschließend beispielsweise mithilfe einer Vakuumpumpe 30 die im Inneren der Prüfhülle 2 verbleibende Luft abgesaugt und ein Unterdruck erzeugt. Aufgrund der Flexibilität der Wandung 12 und allgemein der Kunststofffolie 10 schmiegt sich die Wandung 12 flächig und der Außenkontur des Kabelsatzes 4 folgend an diese Außenkontur an. Hierbei wird ein Unterdruck gegenüber dem in der Umgebung herrschenden Druck von beispielsweise 300 bis 800 hPa erzeugt.

Zur Messung der Integrität der Isolierung 24 wird vorzugsweise jeweils an einen der beiden äußeren zweiten Kontaktanschlüsse 26B mithilfe eines Test- oder Messgeräts 32 eine Prüfspannung U1 angelegt, die beispielsweise zumindest dem Spannungswert einer Betriebsspannung entspricht, mit der der Kabelsatz 4 im Betrieb beaufschlagt wird. Vorzugsweise wird jedoch eine deutlich höhere Spannung als die Betriebsspannung angelegt. Beispielsweise wird eine Prüfspannung von 1.000 Volt oder mehr angelegt. Beispielsweise wird eine Prüfspannung größer 1.500V und allgemein beispielsweise im Bereich zwischen 1kV bis 5kV angelegt.

Die Spannung U1 wird insbesondere zwischen jeweils einem der beiden Kontaktanschlüsse 26B und dem Messanschluss 16 angelegt. Mithilfe des Messgeräts 32 wird bevorzugt ein evtl. fließender Leckstrom als Maß für den Widerstand der Anordnung gemessen.

Für den Fall einer intakten Isolierung 24 fließt kein oder nur ein sehr geringer Leckstrom. Im Falle einer defekten Isolierung 24 treten beispielsweise Überschläge oder sogar eine Kontaktierung zwischen dem Leiter 22 und der Prüfhülle 2 auf, so dass dies zu einem messbaren signifikant höherem Leckstrom führen. Es wird aufgrund des gemessenen Leckstroms erkannt, ob die Isolation 24 den Qualitätsanforderungen entspricht. Innerhalb des Messgerätes 32 sind vorzugsweise Schwellenwerte für unzulässig hohe Leckströme parametriert.

Der besondere Vorteil der hier vorgestellten Methode ist darin zu sehen, dass zum einen der Kabelsatz 4 zumindest weitgehend vollständig oder vollständig in der Prüfhülle 2 einliegt und damit der Kabelsatz 4 durch nur eine Messung vollständig auf Isolationsschäden überprüft wird. Insbesondere werden hierbei auch Konfektionierungsfehler beim Anschließen der Kontaktanschlüsse 26B erkannt, da diese ebenfalls in der Prüfhülle 2 einliegen. Gleiches gilt für die Verteiler 28.

In der Fig. 2 ist ein Ausführungsbeispiel dargestellt, bei dem auch die ersten Kontaktanschlüsse 26A im Inneren der Prüfhülle 2 beim Prüfverfahren einliegen. Bei dieser Ausführungsvariante werden daher auch diese bei der Prüfung mit überprüft.

Für diese Variante gemäß Fig. 2 ist insbesondere vorgesehen, dass die Prüfhülle 2 integrierte Anschlusselemente 34 aufweist. Diese sind insbesondere fester Bestandteile der Prüfhülle 2 und beispielsweise mit der Wandung 12 fest verbunden. Diese Anschlusselemente 34 sind insbesondere als Steckelemente ausgebildet und bilden Gegenstecker für die Kabelsatzstecker, also speziell für die ersten Kontaktanschlüsse 26A. Die Anschlusselemente 34 selbst sind vorzugsweise luftdicht zur Wandung 12 hin abgedichtet und bilden quasi Durchführungen. Die Anschlusselemente 34 sind dabei vorzugsweise wiederum mittels Durchführungselementen 18, wie sie bereits zu der Fig. 1A beschrieben wurden, abgedichtet. Die Anschlusselemente 34 sind beispielsweise im aufgefalteten Ausgangszustand der Folienlage 6 (vgl. hierzu Fig. 1A) beispielsweise mit den unteren Halbschalen der Durchführungselemente 18 verbunden oder bilden mit diesen ein integrales, einstückiges Element aus.

An diese Anschlusselemente 34 ist außenseitig das Messgerät 32 zum Anlegen der Prüfspannung U1 angeschlossen. Hierzu weist das Anschlusselement 34 vorzugsweise einen außenseitig liegenden Anschlusskontakt 36, beispielsweise eine Steckbuchse oder einen Steckerstift auf.

Fig. 3 zeigt eine Stirnansicht von außen auf eine Stirnseite der Prüfhülle 2 im Bereich der Anschlusselemente 34. In der Stirnansicht der Fig. 3 sind weiterhin die Durchführungselemente 18 mit den beiden Halbschalen zu erkennen, die der Außenkontur des Anschlusselements 34 folgend um dieses herum geführt sind. Weiterhin sind die Kunststofffolie 10 sowie die Verschlusselemente 8 zu erkennen, die beispielsweise nach Art von leistenartigen Clip-Verschlüssen ausgebildet sind.

Fig. 4 zeigt einen speziellen Aufbau der Wandung 12 der Prüfhülle 2. Und zwar ist in diesem Ausführungsbeispiel vorgesehen, dass die Wandung 2 gebildet ist durch eine äußere, insbesondere isolierende Lage, die durch eine Kunststofffolie 10 gebildet ist und eine innere leitfähige Lage, die insbesondere durch ein Gewebe oder Geflecht 38 gebildet ist. Dieses besteht beispielsweise aus feinen und feinsten Metalldrähten oder auch aus metallisierten Kunststoff- oder Textilfäden. Zu erkennen ist in dieser Querschnittsdarstellung auch der Aufbau des Kabels 20 mit dem innenliegenden Leiter 22 und der Isolation 24 (Adermantel).

Weiterhin ist zu erkennen, dass in diesem Ausführungsbeispiel der Messanschluss 16 gebildet ist durch ein bolzenförmiges Element, welches innenseitig das Geflecht 38 kontaktiert und nach außen geführt ist. Im Ausführungsbeispiel handelt es sich hierbei speziell um einen Schraubbolzen, speziell mit einem innenseitig angeordneten Flachkopf beispielsweise mit linsenförmigem Kopf. Mittels einer Mutter ist die Schraube mit der Wandung 12 mechanisch fest verbunden. Im Ausführungsbeispiel ist dargestellt, dass die Schraube zwei Lagen des Geflechts 38 gegen eine Lage der Kunststofffolie 10 verspannt. Alternativ wird nur eine Lage des Geflechts 38 verspannt. An diesen Messanschluss 16 wird das Messgerät 32 beispielsweise mittels einer Klemme elektrisch angeschlossen.

Wesentlich für das hier dargestellte Verfahren ist die hohe Flexibilität der Wandung 12, sodass diese sich mit ihrer leitfähigen Lage an den Kabelsatz 4 und dessen Außenkontur anschmiegt. Um dies zu erreichen weist die Wandung 12 eine vergleichsweise geringe Dicke D auf. Diese liegt vorzugsweise bei maximal 300 µm oder auch darunter, je nach Ausgestaltung und Aufbau der Wandung 12. Die Dicke der Wandung ist dabei durch den gesamten Aufbau der Wandung 12 definiert, bei einem einlagigen Aufbau durch die Dicke D der einen Lage, z.B. der Kunststofffolie 10, und bei einem mehrlagigen Aufbau durch die Gesamtdicke der mehreren Lagen.

### Bezugszeichenliste

- 2: Prüfhülle
- 4: HV-Kabelsatz
- 6: Folienlage
- 6A: Unterteil
- 6B: Oberteil
- 8: Verschlusselement
- 10: Kunststofffolie
- 12: Wandung
- 14: Sauganschluss
- 16: Messanschluss
- 18: Durchführungselement
- 20: Kabel
- 22: Leiter
- 24: Isolation
- 26A: erste Kontaktanschlüsse
- 26B: zweite Kontaktanschlusse
- 28: Verteiler
- 30: Vakuumpumpe
- 32: Messgerät
- 34: Anschlusselement
- 36: Anschlusskontakt
- 38: Geflecht

- D: Dicke
- U1: Prüfspannung

## Patentansprüche

1. Verfahren zur Prüfung der Isolation (24) eines elektrischen Bauteils, insbesondere eines HV-Kabelsatzes (4), wobei das elektrische Bauteil einen elektrischen Kern aufweist, der von der zu prüfenden Isolation (24) umgeben ist, wobei
- eine Prüfhülle (2) bereitgestellt wird, in der das zu prüfende Bauteil bei der Prüfung zumindest weitgehend vollständig einliegt,
- die Prüfhülle als eine Prüftasche ausgebildet ist, die zwei gegenüberliegende Hüllflächen aufweist, die zumindest bei der Durchführung des Prüfverfahrens an zumindest drei Randseiten miteinander verbunden sind, wobei die Prüftasche einen Prüfraum umschließt und in der Prüftasche das elektrische Bauteil einliegt,
- die Prüfhülle (2) eine elektrisch leitfähige Wandung (12) aus einem flexiblen Material aufweist und es sich bei der Wandung (12) um eine folienartige oder stoffartige Umhüllung handelt,
- die Prüfhülle (2) sich durch ihre Flexibilität an die Außenkontur der Isolation (24) anlegt,
- an den elektrischen Kern eine Prüfspannung angelegt wird und geprüft wird, ob die Isolation (24) schadhaft ist.

2. Verfahren nach dem vorhergehenden Anspruch, bei dem darauf verzichtet ist, in einen Zwischenraum zwischen der als Elektrode dienenden Prüfhüllle (2) und der Isolation (24) ein Prüfmedium einzubringen.

3. Verfahren nach einem der vorhergehenden Ansprüche, bei dem die als eine Prüftasche ausgebildete Prüfhülle (2) nur zu einer Seite eine insbesondere verschließbare Öffnung aufweist, wobei durch die Öffnung vorzugsweise zumindest ein Ende oder ein Kontaktanschluss (26A, 26B) des elektrischen Bauteils herausgeführt ist an der Öffnung ein Anschlusselement (34) angeordnet ist.

4. Verfahren nach einem der vorhergehenden Ansprüche, bei dem in der Prüfhülle (2) ein Unterdruck erzeugt wird, so dass sich die Prüfhülle (2) an die Isolation (24) anschmiegt und die Isolation (24) großflächig, insbesondere vollflächig berührt.

5. Verfahren nach einem der vorhergehenden Ansprüche, bei dem die Prüfhülle (2) einen Sauganschluss (14) zum Erzeugen des Unterdrucks aufweist.

6. Verfahren nach einem der vorhergehenden Ansprüche, bei dem die Prüfhülle (2) bei einliegendem Bauteil luftdicht verschließbar ist und hierzu vorzugsweise zumindest ein Verschlusselement (8) aufweist.

7. Verfahren nach einem der vorhergehenden Ansprüche, bei dem die Prüfhülle (2) einen Messanschluss (16) zum Anschluss eines Messgeräts (32) aufweist.

8. Verfahren nach einem der vorhergehenden Ansprüche, bei dem in der Prüfhülle (2) zumindest ein endseitiger Kontaktanschluss (26A, 26B) des Bauteils einliegt.

9. Verfahren nach einem der vorhergehenden Ansprüche, bei dem die Prüfhülle (2) ein integriertes Anschlusselement (34) aufweist, an das das Bauteil im Inneren der Prüfhülle (2) anschließbar ist, wobei das Anschlusselement (34) insbesondere abgedichtet durch die Wandung (12) der Prüfhülle (2) geführt ist.

10. Verfahren nach einem der vorhergehenden Ansprüche, bei dem die Wandung (12) eine Dicke (D) im Bereich bis maximal 300 µm, vorzugsweise maximal 200 µm oder maximal 100 µm aufweist.

11. Verfahren nach einem der vorhergehenden Ansprüche, bei dem die Wandung (12) der Prüfhülle (2) durch eine leitfähige Kunststofffolie (10) oder durch eine mit einer leitfähigen Beschichtung versehene Kunststofffolie (10) gebildet ist, und/ oder
bei dem die Wandung (12) der Prüfhülle (2) eine Folie sowie eine weitere, leitfähige Lage aufweist, die insbesondere durch ein Gewebe gebildet ist..

12. Verfahren nach einem der vorhergehenden Ansprüche, bei dem die Wandung (12) der Prüfhülle (2) im Ausganszustand als eine Folienlage (6) ausgebildet ist und das zu prüfende Bauteil auf einen Teil (6A) der Prüfhülle (2) aufgelegt wird und anschließend ein weiteres Teil (6B) der Prüfhülle (6A) über das zu prüfende Bauteil gelegt wird.

13. Verfahren nach einem der vorhergehenden Ansprüche, bei dem das Bauteil nach der Prüfung in der Prüfhülle (2) verbleibt und diese als eine Transportverpackung verwendet wird.

14. Vorrichtung zur Prüfung der Isolation (24) eines elektrischen Bauteils, insbesondere eines HV-Kabelsatzes (4), die eine Prüfhülle (2) aufweist, , die zwei gegenüberliegende Hüllflächen aufweist, die zumindest bei der Durchführung des Prüfverfahrens an zumindest drei Randseiten zur Ausbildung einer Prüftasche miteinander verbunden sind, wobei die Prüftasche einen Prüfraum umschließt und in die Prüftasche das zu prüfende elektrische Bauteil einlegbar ist und eine Wandung (12) aus einem elektrisch leitfähigem Material aufweist, wobei es sich bei der Wandung (12) um eine folienartige oder stoffartige Umhüllung handelt, und die Prüfhülle (2) durch die Wandung (12) zur Umgebung hin luftdicht abgeschlossen ist und die Prüfhülle (2) eine Flexibilität aufweist, so dass sie sich durch ihre Flexibilität an die Außenkontur der Isolation (24) anlegen kann, wobei die Prüfhülle (2) vorzugsweise ein oder mehrere der nachfolgenden Merkmale aufweist:
- einen Sauganschluss (14) zum Erzeugen eines Unterdrucks innerhalb der Prüfhülle (2),
- ein integriertes Anschlusselement (34) zum Anschluss eines Kontaktanschlusses (26A) des zu prüfenden Bauteils im Innern der Prüfhülle (2),
- zumindest ein Verschlusselement (8) zum luftdichten Verschließen der Prüfhülle (2) sowie
- einen Messanschluss (16) zum Anschließen eines Messgerätes (32).

## Claims

1. Method for testing the insulation (24) of an electrical component, in particular of a HV cable set (4), the electrical component having an electrical core which is surrounded by the insulation (24) to be tested, wherein
- a test sheath (2) is provided, in which the component to be tested is at least largely completely enclosed during the test,
- the test sheath is designed as a test pocket which has two opposite sheath surfaces which are connected to one another on at least three edge sides at least when the test method is being carried out, the test pocket enclosing a test space and the electrical component being inserted in the test pocket,
- the test sheath (2) has an electrically conductive wall (12) made of a flexible material and the wall (12) is a film-like or fabric-like sheath,
- the test sheath (2) fits to the outer contour of the insulation (24) by its flexibility,
- a test voltage is applied to the electrical core and it is tested whether the insulation (24) is defective.

2. Method according to the preceding claim, in which a test medium is not introduced into a gap between the test sheath (2) serving as an electrode and the insulation (24).

3. Method according to one of the preceding claims, in which the test sheath (2), which is in the form of a test pocket, has an opening, in particular a closable opening, on only one side, at least one end or a contact terminal (26A, 26B) of the electrical component preferably being led out through the opening, and a connecting element (34) being arranged at the opening.

4. Method according to one of the preceding claims, in which a negative pressure is generated in the test sheath (2), so that the test sheath (2) fits closely against the insulation (24) and touches the insulation (24) over a large area, in particular over the entire area.

5. Method according to one of the preceding claims, in which the test sheath (2) has a suction connection (14) for generating the negative pressure.

6. Method according to one of the preceding claims, in which the test sheath (2) can be closed in an airtight manner when the component is inserted and preferably has at least one closure element (8) for this purpose.

7. Method according to one of the preceding claims, in which the test sheath (2) has a measuring connection (16) for connecting a measuring device (32).

8. Method according to any one of the preceding claims, wherein at least one end contact terminal (26A, 26B) of the component is inserted in the test sheath (2).

9. Method according to one of the preceding claims, in which the test sheath (2) has an integrated connection element (34) to which the component is connectable in the interior of the test sheath (2), the connection element (34) being guided in particular in a sealed manner through the wall (12) of the test sheath (2).

10. Method according to one of the preceding claims, in which the wall (12) has a thickness (D) in the range up to a maximum of 300 µm, preferably a maximum of 200 µm or a maximum of 100 µm.

11. Method according to one of the preceding claims, in which the wall (12) of the test sheath (2) is formed by a conductive plastic film (10) or by a plastic film (10) provided with a conductive coating, and/or
in which the wall (12) of the test sheath (2) has a film and a further conductive layer which is formed in particular by a fabric.

12. Method according to one of the preceding claims, in which the wall (12) of the test sheath (2) is formed as a film layer (6) in the initial state and the component to be tested is placed on a part (6A) of the test sheath (2) and then a further part (6B) of the test sheath (6A) is placed over the component to be tested.

13. Method according to any one of the preceding claims, in which the component remains in the test sheath (2) after testing and the latter is used as a transport packaging.

14. Device for testing the insulation (24) of an electrical component, in particular a HV cable set (4), which has a test sheath (2) which has two opposite enveloping surfaces which are connected to one another on at least three edge sides to form a test pocket, at least when the testing method is being carried out, the test pocket enclosing a test space and the electrical component to be tested being insertable into the test pocket and having a wall (12) made of an electrically conductive material, the wall (12) being a film-like or fabric-like sheath, and the test sheath (2) being sealed off from the environment in an airtight manner by the wall (12), and the test sheath (2) having a flexibility such that it can, by virtue of its flexibility, fit to the outer contour of the insulation (24), the test sheath (2) preferably having one or more of the following features:
- a suction connection (14) for generating a negative pressure within the test sheath (2),
- an integrated connection element (34) for connecting a contact terminal (26A) of the component to be tested inside the test sheath (2),
- at least one closure element (8) for closing the test sheath (2) in an airtight manner, and
- a measuring connection (16) for connecting a measuring device (32).

## Revendications

1. Procédé pour vérifier l'isolation (24) d'un composant électrique, en particulier d'un faisceau de câbles haute tension (4), le composant électrique comportant une âme électrique qui est entourée de l'isolation (24) à vérifier, dans lequel
- on fournit une enveloppe de vérification (2), dans laquelle le composant à vérifier est au moins en grande partie complètement inséré lors de la vérification,
- l'enveloppe de vérification est configurée sous forme d'une poche de vérification qui comporte deux faces d'enveloppe se faisant face qui, au moins lors de l'excéution du processus de vérification, sont jointes l'une à l'autre sur les bords d'au moins trois côtés, la poche de vérification renfermant un espace de vérification et le composant électrique étant inséré dans la poche de vérification,
- l'enveloppe de vérification (2) comporte une paroi (12) conductrice de l'électricité, en un matériau flexible, et pour ce qui est de la paroi (12) il s'agit d'une enveloppe de type film ou de type tissu,
- l'enveloppe de vérification (2) s'applique, grâce à sa flexibilité, sur le contour externe de l'isolation (24),
- on applique une tension de vérification sur l'âme électrique et on examine si l'isolation (24) est défectueuse.

2. Procédé selon la revendication précédente, dans lequel on s'abstient d'introduire un milieu d'essai dans un espace intermédiaire entre l'enveloppe de vérification (2) servant d'électrode et l'isolation (24).

3. Procédé selon l'une quelconque des revendications précédentes, dans lequel l'enveloppe de vérification (2) configurée en tant qu'une poche de vérification ne comporte qu'en un côté une ouverture en particulier pouvant être fermée, de préférence au moins une extrémité ou une borne (26A, 26B) du composant électrique étant passée en sortant à travers l'ouverture, et un élément de connexion (34) étant disposé sur l'ouverture.

4. Procédé selon l'une quelconque des revendications précédentes, dans lequel une dépression est engendrée dans l'enveloppe de vérification (2), de sorte que l'enveloppe de vérification (2) s'accole à l'isolation (24) et vient en contact avec l'isolation (24) sur une grande partie, en particulier la totalité, de sa surface.

5. Procédé selon l'une quelconque des revendications précédentes, dans lequel l'enveloppe de vérification (2) comporte un raccord d'aspiration (14) destiné à la production de la dépression.

6. Procédé selon l'une quelconque des revendications précédentes, dans lequel l'enveloppe de vérification (2) peut être fermée de façon étanche à l'air lorsque le composant est inséré et à cette fin comporte de préférence au moins un élément de fermeture (8).

7. Procédé selon l'une quelconque des revendications précédentes, dans lequel l'enveloppe de vérification (2) comporte un raccord de mesure (16) destiné au raccordement d'un appareil de mesure (32).

8. Procédé selon l'une quelconque des revendications précédentes, dans lequel au moins une borne (26A, 26B) d'extrémité du composant est insérée dans l'enveloppe de vérification (2).

9. Procédé selon l'une quelconque des revendications précédentes, dans lequel l'enveloppe de vérification (2) comporte un élément de raccordement (34) intégré, auquel le composant peut être raccordé à l'intérieur de l'enveloppe de vérification (2), l'élément de raccordement (34) étant passé, en particulier de manière étanche, à travers la paroi (12) de l'enveloppe de vérification (2).

10. Procédé selon l'une quelconque des revendications précédentes, dans lequel la paroi (12) présente une épaisseur (D) dans la plage allant jusqu'à un maximum de 300 µm, de préférence un maximum de 200 µm ou un maximum de 100 µm.

11. Procédé selon l'une quelconque des revendications précédentes, dans lequel la paroi (12) de l'enveloppe de vérification (2) est constituée d'un film de matière plastique (10) conducteur ou d'un film de matière plastique (10) muni d'un revêtement conducteur, et/ou
dans lequel la paroi (12 de l'enveloppe de vérification (2) comporte un film ainsi qu'une autre couche, conductrice, qui est constituée en particulier d'un tissu.

12. Procédé selon l'une quelconque des revendications précédentes, dans lequel la paroi (12) de l'enveloppe de vérification (2) est configurée à l'état initial sous forme d'une couche de film (6) et le composant à vérifier est déposé sur une partie (6A) de l'enveloppe de vérification (2) et ensuite une autre partie (6B) de l'enveloppe de vérification (6A) est placée sur le composant à vérifier.

13. Procédé selon l'une quelconque des revendications précédentes, dans lequel après la vérification le composant reste dans l'enveloppe de vérification (2) et cette dernière est utilisée en tant qu'un emballage de transport.

14. Dispositif destiné la vérification de l'isolation (24) d'un composant électrique, en particulier d'un faisceau de câbles haute tension (4), qui comporte une enveloppe de vérification (2), qui comporte deux faces d'enveloppe se faisant face qui, au moins lors de l'exécution du processus de vérification, sont jointes l'une à l'autre sur les bords d'au moins trois côtés pour la formation d'une poche de vérification, la poche de vérification renfermant un espace de vérification et le composant électrique à vérifier étant insérable dans la poche de vérification, et comporte une paroi (12) en un matériau conducteur de l'électricité, la paroi (12) consistant en une enveloppe de type film ou de type tissu, et l'enveloppe de vérification (2) étant fermée vis-à-vis de l'environnement, de façon étanche à l'air, par la paroi (12) et l'enveloppe de vérification (2) présentant une flexibilité, de sorte qu'elle peut s'appliquer, grâce à sa flexibilité, sur le contour externe de l'isolation (24), dans lequel l'enveloppe de vérification (2) présente de préférence une ou plusieurs des caractéristiques suivantes :
- un raccord d'aspiration (14) destiné à la production d'une dépression à l'intérieur de l'enveloppe de vérification (2),
- un élément de raccordement (34) intégré, destiné au raccordement d'une borne (26A) du composant à vérifier à l'intérieur de l'enveloppe de vérification (2),
- au moins un élément de fermeture (8) destiné à la fermeture de manière étanche à l'air de l'enveloppe de vérification (2) ainsi que
- un raccord de mesure (16) destiné au raccordement d'un appareil de mesure (32).
